# EUROPÄISCHE PATENTSCHRIFT

(11) **EP 4 038 396 B1**
(45) Veröffentlichungstag und Bekanntmachung des Hinweises auf die Patenterteilung: **04.12.2024**
(21) Anmeldenummer: 20790201.6
(22) Anmeldetag: 01.10.2020
(51) Int. Cl.: G01R 1/04, G01R 31/28

(54) **ANORDNUNG ZUR FUNKTIONSÜBERPRÜFUNG EINES MESSOBJEKTES**
ASSEMBLY FOR CHECKING THE FUNCTIONALITY OF A MEASURING OBJECT
SYSTÈME POUR VÉRIFIER LA FONCTIONNALITÉ D'UN OBJET DE MESURE

(30) Priorität: 01.10.2019 DE 102019215126
(43) Veröffentlichungstag der Anmeldung: 10.08.2022
(73) Patentinhaber: Neuroloop GmbH, 79110 Freiburg (DE)
(72) Erfinder: KIMMIG, Fabian, 79110 Freiburg (DE); BORETIUS, Tim, 79110 Freiburg (DE); DOBLER, Janosch, 79110 Freiburg (DE); GOSLICH, Christian, 79110 Freiburg (DE); KEMPTER, Daniel, 79110 Freiburg (DE)
(74) Vertreter: Rösler, Uwe
(86) Internationale Anmeldenummer: PCT/EP2020/077481
(87) Internationale Veröffentlichungsnummer: WO 2021/064087

(56) Entgegenhaltungen:
- EP-A1- 0 898 172
- WO-A1-2015/069522
- CN-A- 107 064 776
- CN-A- 109 143 028
- CN-A- 109 975 640
- US-A1- 2002 079 912
- US-A1- 2004 010 388
- US-A1- 2007 005 118
- US-A1- 2018 031 629

## Beschreibung

### Technisches Gebiet

Die Erfindung bezieht sich auf eine Anordnung zur Funktionsüberprüfung eines Meßobjektes, ein sogenanntes DUT, in Form eines medizinischen Implantats oder wenigstens eines Teils des medizinischen Implantats.

### Stand der Technik

Implantierbare medizinische Vorrichtungen zum Zwecke der elektrischen Stimulation lokaler intrakorporaler Bereiche, kurz Implantierbare Pulsgeber (IPG) beispielsweise für herztherapeutische Defibrillations-, Schrittmacher- sowie Resynchronisationsanwendungen, für neurostimulationstherapeutische Maßnahmen, wie bspw. Rückenmarkstimulation, Hirnstimulation oder Vagusnervstimulation, um nur einige zu nennen, weisen in aller Regel ein in sich fluiddicht abgeschlossenes Gehäuse auf, in dem Komponenten zur elektrischen Pulsgeneration enthalten sind, so zumindest eine elektrische Energiequelle, in Form einer Batterie oder einer Induktionsspule, und eine mit dieser verbundenen elektrischen Schaltungsstruktur. Zudem schließt zumeist an das Gehäuse ein sogenanntes Kopfteil an, in dem eine mit der Energiequelle bzw. der elektrischen Schaltungsstruktur elektrisch verbundene, elektrische Kontaktanordnung enthalten ist, in die eine fluiddicht mit dem Kopfteil abschließende Steckeranordnung einfügbar ist, die mit elektrischen Zu- und Ableitungen zum Zwecke der intrakorporalen lokalen Applikation der elektrischen Stimulationssignale sowie gegebenenfalls der Zuführung intrakorporal lokal abgegriffener elektrischer Signale zur Gehäuse-seitig vorhandenen elektrischen Schaltungsstruktur, kontaktiert ist.

Mit zunehmenden Funktionsumfang des medizinischen Implantates nimmt auch die Anzahl der innerhalb des Implantats verbauten elektrischen bzw. elektronischen Komponenten zu, die aufgrund minimaler Raumerfordernisse dicht gepackt und komplex miteinander verschaltet auf wenigstens einer Leiterplatine angeordnet sind. Die für den Betrieb des medizinischen Implantates erforderliche elektrische Energie wird entweder durch eine innerhalb des Implantates integrierte Batterie oder im Wege einer induktiven Energieübertragung zur Verfügung gestellt.

Sowohl für die Entwicklung und Herstellung von Implantaten als auch zur Qualitätskontrolle und -sicherung in der Produktion von medizinischen Implantaten in großer Stückzahl sind Überprüfungs- und Kontrollprozeduren unerlässlich. Um eine Verschleppung von während des Produktionsprozesses auftretenden Fehlern auszuschließen, werden messtechnische Untersuchungen an funktionsbestimmenden Komponenten während des gesamten Fertigungsprozesses, jeweils an unterschiedlichen Ausbaustufen eines medizinischen Implantates durchgeführt. Von besonderer Relevanz sind in diesem Zusammenhang jeweils die Reproduzierbarkeit und Protokollfähigkeit der einzelnen Funktionsüberprüfungen. Die Druckschrift US 2018/9931629 A1 offenbart eine Testanordnung zur Funktionsprüfung einer Halbleiterbauelementanordnung, bei der die zu untersuchende Halbleiterbauelementanordnung in einer Prüfbuchse angeordnet ist, die kabellos mit Testsignalen beaufschlagt wird.

Die Druckschrift US2002/0079912 A1 offenbart eine Prüfanordnung für elektrische Leiterplatinen, die zu Prüfzwecken in eine Prüfbuchse einlegbar sind und mit elektrischen Prüfsignalen beaufschlagbar sind.

Die Druckschrift DE 20 2006 000 739 U1 offenbart eine Vorrichtung zum Testen elektronischer Bauelemente, insbesondere Bauelemente mit integrierten Schaltungen, mit einem Kontaktsockel, in den ein zu prüfenden Bauelement in Anlage bringbar ist.

Die Druckschriften CN 109 143 028 A, CN 107 064 776 A, US 2007/005118 A1, CN 109 975 640 A sowie WO 2015/069522 A1 offenbaren Anordnungen zur Funktionsüberprüfung eines medizinischen Implantats.

### Darstellung der Erfindung

Der Erfindung liegt die Aufgabe zugrunde, eine Anordnung zur Funktionsprüfung eines Messobjektes, vorzugsweise in Form eines medizinischen Implantates oder wenigstens eines Teils eines medizinischen Implantates derart anzugeben, so dass Funktionsüberprüfungen an fertigen Produkten, vorzugsweise von medizinischen Implantaten, oder Teilen von diesen, die sowohl in kleiner Losgröße als auch im industriellen Maßstab gefertigt werden, sicher, zuverlässig und mit einer belastbaren Reproduzierbarkeit vorgenommen werden können, die zudem protokollfähig sind, um Gewährleistungsansprüchen zu genügen.

Die der Erfindung zugrunde liegende Aufgabe ist im Anspruch 1 angegeben. Den Erfindungsgedanken in vorteilhafter Weise weiterbildende Merkmale sind Gegenanstand der Unteransprüche sowie der weiteren Beschreibung insbesondere unter Bezugnahme auf illustrierte Ausführungsbeispiele zu entnehmen.

Die lösungsgemäße Anordnung zur Funktionsüberprüfung eines Messobjektes, das in Form eines medizinischen Implantats oder wenigstens eines Teils eines medizinischen Implantats vorliegt und im weiteren als DUT (Device Under Test) bezeichnet wird, setzt sich im Wesentlichen aus einem Testsignal-Generator, einem Testmodul, einem in das Testmodul einsetzbaren Adaptermodul und einer Steuer- und Auswerteeinheit zusammen.

Der vorzugsweise über eine elektrische Schnittstelle mit dem Testmodul verbundene Testsignal-Generator generiert die zur Prüfung des DUT erforderlichen Testsignale, die über das Testmodul mittelbar auf das DUT übertragen werden. Grundsätzlich eignen sich an sich bekannte Testsignalgeneratoren mit fest oder frei wählbar vorgebbaren elektrischen Testsignalen. Je nach Art und Einsatzzweck des zu überprüfenden DUTs vermag der Testsignalgenerator bspw. EKG-Signale nachzubilden oder elektrische Signalformen zu generieren, die bspw. neuronalen elektrischen Signalen entsprechen. Vorzugsweise eignet sich ein Testsignal-Generator zur Erzeugung elektrischer Spannungen mit einem beliebig vorgebbaren Zeitverlauf und zeitlich periodischer Wiederkehr, die ebenfalls individuell vorgebbar ist. Bevorzugte Testsignal-Generatoren stellen beispielsweise analoge oder digitale Funktionsgeneratoren dar.

Das mit dem Test-Signalgenerator vorzugsweise über ein Verbindungskabel verbundene Testmodul verfügt in einer einfachsten Ausführungsform über eine erste Aufnahmestruktur mit wenigstens einer, vorzugsweise einer Vielzahl von Kontaktelektroden, in die ein mit dem DUT lösbar fest verbundenes Adaptermodul unter Ausbildung wenigstens eines elektrischen Kontaktes einsetzbar ist.

Das Testmodul besitzt ein Gehäuse, in dem eine erste Aufnahmestruktur, vorzugsweise in Form einer Ausnehmung innerhalb des Gehäuses vorgesehen ist, in die das mit dem DUT lösbar fest verbundene Adaptermodul unter Ausbildung eines Formschlusses einsetzbar ist. Die sich durch das Einsetzen des Adaptermoduls in die erste Aufnahmestruktur ausbildende Formschlussverbindung sorgt für einen eineindeutigen Sitz des Adaptermoduls innerhalb der ersten Aufnahmestruktur und somit auch des DUTs relativ zur ersten Aufnahmestruktur des Testmoduls. Zugleich bildet sich eine elektrische Verbindung zwischen wenigstens einer im Bereich der Ausnehmung der ersten Aufnahmestruktur angebrachten Kontaktelektrode mit dem Adaptermodul aus.

Ergänzend zum Formschluss ist das Adaptermodul optional per zusätzlicher Kraftschlussverbindung am Testmodul fixiert, beispielsweise durch Vorsehen einer Federkraft-beaufschlagten Klemm- oder Rastverbindung zwischen Adaptermodul und Testmodul. Selbstverständlich können auch alternative Halterungsmaßnahmen unmittelbar oder mittelbar am Testmodul vorgesehen sein, die das Adaptermodul raumfest relativ zum Testmodul lösbar fest zu fixieren vermögen.

Durch Vorsehen der ersten Aufnahmestruktur innerhalb des Testmoduls ist gewährleistet, dass eine Vielzahl jeweils baugleich oder unterschiedlich ausgebildeter DUTs, die jeweils in einem individuell an das DUT angepasste Adaptermodul eingesetzt sind, das in die einheitlich ausgebildete Aufnahmestruktur einsetzbar ist, unter exakt gleichen Prüfbedingungen, d.h. jeweils unter Einhaltung einer definierten Raumlage und elektrischen Kontaktierung, überprüft werden kann. Auf diese Weise können reproduzierbare, belastbare Prüfaussagen zum DUT getroffen werden.

Somit steht ein und dasselbe Testmodul für die Prüfung einer Vielzahl unterschiedlich konfektionierter DUTs, die jeweils in ein individuell an das jeweilige DUT angepasstes Adaptermodul eingesetzt sind, das wiederum in die erste Aufnahmestruktur der Testbox einsetzbar ist, zur Verfügung.

Für die Durchführung einer Prüfung eines DUTs, das mit einem Adaptermodul verbunden ist, das in die erste Aufnahmestruktur eingesetzt ist, werden die von Seiten des Testgenerators generierten Testsignale über das Testmodul und Adaptermodul auf das DUT übertragen. Hierzu sind in Abhängigkeit von Anzahl und Anordnung der am DUT angebrachten elektrischen Kontaktstellen, im Weiteren als Gegenelektroden bezeichnet, am Testmodul sowie adaptermodulseitig korrespondierende Kontaktelektroden vorgesehen, über die die Testsignale sowie optional auch Messsignale zwischen Testmodul und DUT übertragen werden können.

Zur Durchführung der Prüfung und Auswertung der erfassten Messsignale dient eine Steuer- und Auswerteeinheit, die mit dem Testsignalgenerator sowie auch dem Testmodul mittel- oder unmittelbar verbunden ist. Die Verbindung kann drahtgebunden oder drahtlos realisiert sein und dient in erster Linie der Übertragung von Steuer- und Messsignalen zwischen den einzelnen Komponenten. Die Steuer- und Auswerteeinheit ist typischerweise in Form eines Rechners oder PCs ausgebildet, der sämtliche für die Messsignalauswertung sowie auch Protokollierung der Messsignale erforderliche Komponenten bzw. Peripheriegeräte wie Speicher, Monitor etc. besitzt.

Das Testmodul verfügt über eine zur ersten Aufnahmestruktur raumfest angeordnete zweite Aufnahmestruktur, in die eine mit dem DUT kontaktlos zum Zwecke einer elektrischen Energie- und/oder Signalübertragung in Wechselwirkung tretende, elektrische Zusatzkomponente, beispielsweise eine Induktionsspulen- und/oder Signalantennenanordnung, fügbar ist.

Im Falle eines DUTs, das über eine Induktionsspuleneinrichtung und/oder Antenneneinrichtung verfügt, kann mit Hilfe der in der zweiten Aufnahmestruktur eingebrachten elektrischen Zusatzkomponente die Funktionsfähigkeit der kontaktlosen Energie- und/oder Signalübertragung zwischen DUT und einer externen Spulen- und Antenneneinheit überprüft werden. Hierzu ist die zweite Aufnahmestruktur in Form einer Schubladenfachartigen Ausnehmung innerhalb des Testmoduls gestaltet, die unmittelbar unterhalb der ersten Aufnahmestruktur angeordnet ist, um so eine definierte Relativlage zwischen dem innerhalb der ersten Aufnahmestruktur mittel angeordneten DUT und des innerhalb der zweiten Aufnahmestruktur platzierten elektrischen Zusatzkomponente zu gewährleisten.

Ergänzend oder alternativ zur Verbindung der Steuer- und Auswerteeinheit mit dem Testmodul, sieht eine bevorzugte Ausführungsform eine kabelgebundene Verbindung zwischen der elektrischen Zusatzkomponente und der Steuer- und Auswerteeinheit vor, längs der sowohl elektrische Energie zur Energieversorgung des DUTs als auch die Übertragung der am DUT abgegriffenen Messsignale und Weiterleitung an die Steuer- und Auswerteeinheit erfolgen kann.

Um sicherzustellen, dass die elektrische Zusatzkomponente raumfest innerhalb der zweiten Aufnahmestruktur implementiert ist, sind die Innenkontur der vorzugsweise schubladenfachartig ausgebildeten zweiten Aufnahmestruktur und ein die elektrische Zusatzkomponente umfassendes Gehäuse einander jeweils gegenkonturiert ausgebildet, so dass ein zuverlässiges Einfügen und Fixieren der elektrischen Zusatzkomponente in die zweite bzw. in der zweiten Aufnahmestruktur unter Ausbildung einer Formschlussverbindung, die optional durch eine zusätzliche Kraftschlussverbindung ergänzt sein kann, möglich werden.

Bei der herstellungsbegleitenden Überprüfung eines medizinischen Implantates nimmt das DUT typischerweise folgende unterschiedliche Bauformen an:
a) In einem ersten Prüfungsstadium gilt es eine mit elektronischen und elektrischen Komponenten bestückte Leiterplatine zu prüfen, um die Funktionsfähigkeit sämtlicher elektrischer/elektronischer Komponenten sicherzustellen und mögliche kalte Lötstellen auszuschließen.
b) In einem daran anschließenden Herstellungsprozess werden elektrische Leitungen mit an der Leiterplatine vorgesehenen Kontaktstellen elektrisch verbunden und zu Zwecken einer räumlich bestimmten Fixierung relativ zueinander mit einer so genannten Durchführungsplatte relativ zueinander fixiert.
c) In einem weiteren Prozessschritt werden die elektrischen Leiterstrukturen mit einer elektrischen Kontaktanordnung kontaktiert, die d) in einem Endausbaustadium des medizinischen Implantats innerhalb eines so genannten Kopfteils Teil einer elektrischen Kontaktstruktur ist, zu, Zwecke der Kontaktierung einer vom medizinischen Implantat wegführenden Kabelverbindung, über die eine separat zum medizinischen Implantat intrakorporal verortete Elektrodenanordnung mit elektrischen Stimulationssignalen beaufschlagbar ist.

In sämtlichen vorstehend erläuterten Herstellungsstufen liegen jeweils unterschiedliche DUTs vor, zu deren Überprüfung die jeweils erste Aufnahmestruktur innerhalb des Testmoduls DUT-individuell anzupassen wäre, um eine jeweils reproduzierbare Prüfsituation zu schaffen.

Das lösungsgemäße Testmodule ist mit einer einheitlichen ersten Aufnahmestruktur ausgebildet, in die jeweils an die erste Aufnahmestruktur angepasst ausgebildete Adaptermodule einsetzbar sind, die jeweils eine dritte Aufnahmestruktur aufweisen, die individuell an ein zu überprüfendes DUT individuell angepasst ist. Die übrige Anordnung betreffend den Testgenerator, das Testmodul, die elektrischen Zusatzkomponenten sowie die Steuer- und Auswerteeinheit verbleiben ansonsten unverändert. Die einzige Maßnahme die für die Prüfung jeweils unterschiedlich ausgebildeter DUTs zu treffen ist, betrifft lediglich das modulartige Auswechseln unterschiedlicher Adaptermodule, die jeweils DUT-individuell konfektionierte dritte Aufnahmestrukturen besitzen.

Zum Zwecke der elektrischen Kontaktierung des DUTs innerhalb der ersten Aufnahmestruktur des Testmoduls bzw. innerhalb der dritten Aufnahmestruktur jeweils eines Adaptermoduls sehen die jeweiligen Aufnahmestrukturen wenigstens eine Anlagefläche auf, an der wenigstens eine Kontaktelektrode angeordnet ist, die mit dem DUT kraft- und formschlüssig mit einer seitens des DUTs angebrachten Gegenelektrode in Kontakt bringbar ist.

In Abhängigkeit der Anzahl, der räumlichen Anbringung und Orientierung der DUTseitig vorgesehenen Gegenelektroden sind die an der wenigstens einen Anlagefläche vorzusehende Kontaktelektroden in geeigneter Form, jeweils gegenkonturiert auszubilden. In einer bevorzugten Ausführungsform ist die wenigstens eine Kontaktelektrode und Gegenelektrode in Art einer Stecker-Buchse-Kontaktstruktur ausgebildet. Alternativ oder in Kombination können die Kontaktelektroden und/oder Gegenelektroden in Form jeweils Federkraftbeaufschlagter, auslenkbar gelagerter Kontaktstifte ausgebildet sein. Auch sind weitere alternative Kontaktelektroden- bzw. Gegenelektroden-Formen und -Strukturen durchaus denkbar.

Für die Prüfung eines endgefertigten medizinischen Implantats in Art eines implantierbaren Pulsgenerator (IPG), das typischerweise ein Versorgungsteil mit den darin enthaltenen elektrischen/elektronischen Komponenten sowie ein daran anschließendes Kopfteil mit wenigstens einer elektrischen Steckerbuchsen-Struktur umfasst, wird das Implantat in eine nach Form und Größe angepasste erste Aufnahmestruktur innerhalb des Testmoduls bzw. dritte Aufnahmestruktur innerhalb eines Adaptermoduls eingelegt. Durch den Einlegevorgang wird das medizinische Implantat an elektrisch zugänglichen Kontaktbereiche, d.h. längs der innerhalb der Steckerbuchsen-Struktur vorgesehenen elektrischen Kontaktelektroden mit geeigneten am Testmodul bzw. Adaptermodul vorgesehenen Kontaktelektroden, kontaktiert. Durch die exakt vorgegebene räumliche Zuordnung zwischen Implantat und der ebenfalls innerhalb des Testmoduls integrierten elektrischen Zusatzkomponente wird das Implantat kontaktfrei mit elektrischer Energie versorgt. Über die in der Steckerbuchsen-Struktur hergestellten elektrischen Kontakte zwischen Implantat und Testmodul bzw. Adaptermodul werden die seitens des Testsignalgenerators erzeugten Testsignale an das medizinische Implantat appliziert. Die für die Funktionsprüfung und Protokollierung der Funktionstüchtigkeit nötigen Messsignale werden über die innerhalb der zweiten Aufnahmestruktur angeordnete elektrische Zusatzkomponente kontaktfrei ausgelesen und der Auswerte- und Steuer-Einheit zugeleitet.

Neben der Verwendung der lösungsgemäß ausgebildeten Anordnung zur Funktionsüberprüfung eignet sich die lösungsgemäße Prüfanordnung auch für eine Aktualisierung des medizinischen Implantats im Rahmen eines Software-Updates, zumal eine Signalübertragung zwischen der elektrischen Zusatzkomponente und dem medizinischen Implantat auch in Richtung des medizinischen Implantats erfolgen kann. Hierzu gilt es mit Hilfe der Auswerte- und Steuereinheit einen aktuellen Betriebsdatensatz in Form elektrischer Datensignale der elektrischen Zusatzkomponente zuzuführen, die die Datensignale kontaktfrei mittels induktiver Kopplung an das medizinische Implantat überträgt, in der die Informationen in einer geeignet vorgesehenen DUT-eigenen Speicher- und Recheneinheit empfangen und entsprechend verarbeitet werden können.

Die lösungsgemäße Anordnung ermöglicht eine belastbare und reproduzierbare Überprüfung medizinischer Implantate. Aufgrund des modularen Baukastenprinzips, durch Vorsehen unterschiedlich designter Adapter- und/oder Testmodule, die jeweils an unterschiedliche Bauformen eines DUTs angepasst sind, kann die gesamte Herstellungshistorie eines medizinischen Implantates überwacht und protokolliert werden. Auf diese Weise wird die Qualitätssicherung bei der Produktion medizinischer Implantate signifikant verbessert.

Auch ermöglicht die lösungsgemäße Anordnung zur Funktionsüberprüfung eine automatisierte Durchführung der Überprüfung von DUTs, zumal sämtliche Komponenten und erforderliche Manipulationsschritte zur Vornahme der Funktionsüberprüfung mit einem geeignet konfektionierten Roboter durchführbar sind.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
- Fig. 1: Übersichtsdarstellung einer Anordnung zur Funktionsüberprüfung
- Fig. 2: unterschiedliche Ausgestaltungsformen für ein DUT,
- Fig. 3: Aufnahmestruktur mit Federkraft-beaufschlagten Kontaktstiften
- Fig. 4: Adaptermodul sowie
- Fig. 5: Aufnahmestruktur mit Stecker-Buchse-Kontakten.

### Wege zur Ausführung der Erfindung, gewerbliche Verwendbarkeit

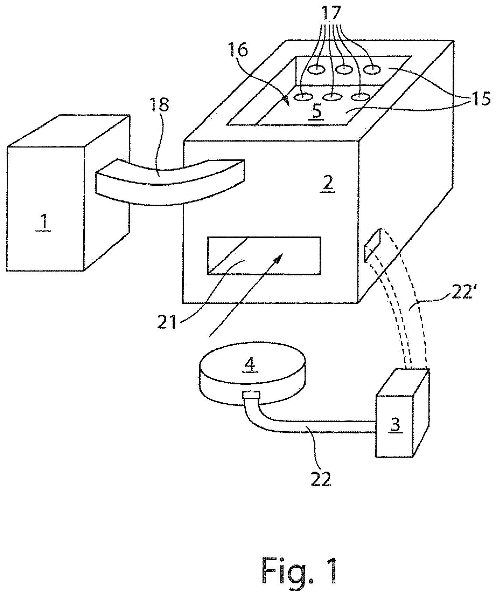

Fig. 1 zeigt eine Gesamtansicht auf eine Anordnung zur Funktionsüberprüfung eines Messobjektes, DUT (Device Under Test) umfassend einen Testsignalgenerator 1, ein Testmodul 2, eine Steuer- und Auswerteeinheit 3, die mit dem Testmodul 2 über eine elektrische Zusatzkomponente 4 zum Zwecke des Energie- und Signalaustausches verbunden ist. Das Kernelement stellt das Testmodul 2 dar, das über eine erste Aufnahmestruktur 5 verfügt, in die ein zu überprüfendes DUT mittel- oder unmittelbar lösbar fest einfügbar und elektrisch kontaktierbar ist.

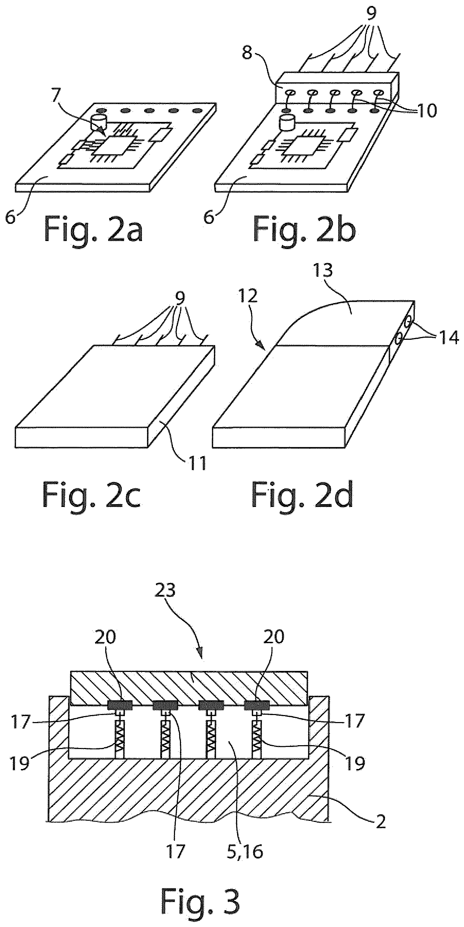

Die lösungsgemäße Anordnung dient der Funktionsüberprüfung und Qualitätssicherung eines medizinischen Implantats während und nach dessen Herstellung. In Fig. 2 sind typische diesbezügliche DUT illustriert, die ein medizinisches Implantat in unterschiedlichen Herstellungsformen zeigt. Fig. 2a zeigt eine erste Herstellungsstufe für den Aufbau eines medizinischen Implantates in Form einer elektrischen Leiterplatte 6 mit darauf angeordneten elektrischen/elektronischen Komponenten 7. Fig. 2b zeigt eine nachfolgend zweite Ausbaustufe, mit einer Durchführungsplatte 8, durch die elektrische Leiter 9 geführt und fixiert sind, die jeweils einseitig mit Kontaktstellen 10 an der Leiterplatte 6 verbunden sind. Fig. 2c zeigt eine Umhausung 11, die vorzugsweise fluiddicht die Leiterplatte 6 sowie die Durchführungsplatte 8 umgibt. Vorzugsweise ist die Umhausung 11 in Form einer erstarrten Epoxidharzmasse oder als Metallgehäuse, bspw. Titangehäuse, ausgebildet. Fig. 2d zeigt ein fertiges medizinisches Implantat 12, das zusätzlich über ein Kopfteil 13 verfügt, das im dargestellten Ausführungsbeispiel zwei Steckerbuchsen 14 aufweist, längs der Kontaktelektroden angeordnet sind, die mit den elektrischen Leitern 9 verbunden sind. In die Steckerbuchsen 14 werden mit intrakorporal verorteten Elektroden verbundene, fluiddicht mit dem Kopfteil 13 abschließende Stecker eingefügt.

Zur Funktionsüberprüfung der einzelnen Ausbaustufen eines medizinischen Implantates 12 gemäß der in Fig. 2a bis d illustrierten unterschiedlich gestalteten DUT weist das in Fig. 1 illustrierte Testmodul 2 eine erste Aufnahmestruktur 5 auf, die eine Ausnehmung 16 innerhalb des Testmoduls 2 mit wenigstens einer Anlagefläche 15 und daran angeordneten Kontaktelektroden 17 vorsieht.

Zur Durchführung der Messung, beispielsweise der in Fig. 2a illustrierten Leiterplatte 6 als DUT werden von Seiten des Testgenerators 1 Testsignale, beispielsweise in Form von EKG-Signalen, generiert und über eine Kabelverbindung 18, die zwischen dem Testsignalgenerator 1 und dem Testmodul 2 verläuft, auf das in der ersten Aufnahmestruktur 5 mittelbar über ein Adaptermodul angeordnete DUT übertragen.

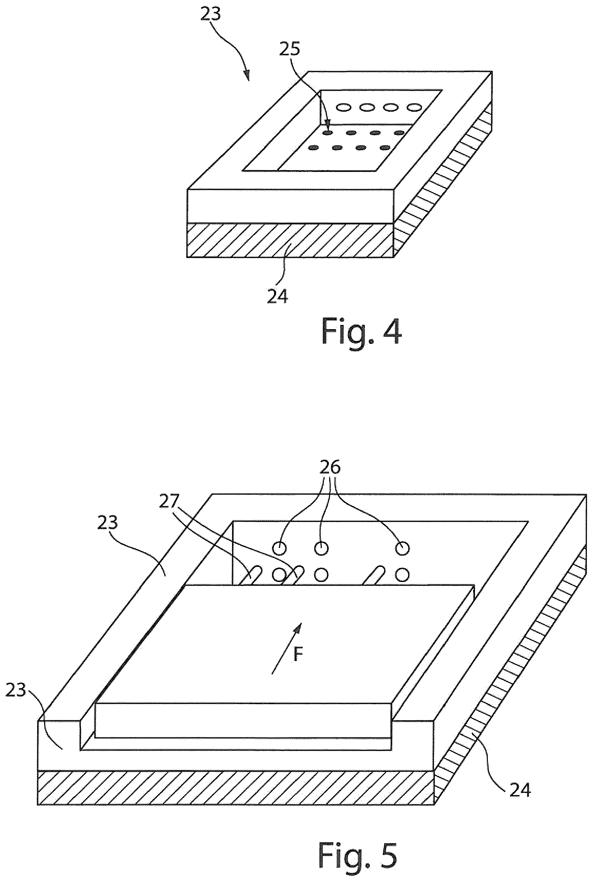

Die in dem Testmodul 2 vorgesehene Aufnahmestruktur 5 ist hierzu derart ausgebildet, dass jeweils an die erste Aufnahmestruktur 5 gegenkonturiert angepasste Adaptermodule 23 einsetzbar sind, siehe Figur 4. Jedes Adaptermodul 23 verfügt über eine einheitliche Fügekontur 24 zum Einsetzen und elektrischen Kontaktieren innerhalb der ersten Aufnahmestruktur 5 des Testmoduls 2. In Abhängigkeit des jeweils zu prüfenden DUTs weist jedes Adaptermodul 23 unterschiedlich konfektionierte dritte Aufnahmestrukturen 25 auf. In die jeweils dritte Aufnahmestruktur 25 sind die in Form und Größe unterschiedlichen DUTs, stets formschlüssig und gegebenenfalls zusätzlich auch kraftschlüssig einsetzbar. Die DUTs werden mit geeignet am Adaptermodul 23 vorgesehenen Kontaktelektroden 25 kontaktiert.

Zur elektrischen Kontaktierung des innerhalb der ersten Aufnahmestruktur 5 räumlich fixierten Adaptermoduls treten zumindest ein Teil der innerhalb der Ausnehmung 16 vorgesehenen Kontaktelektroden 17 in elektrischen Kontakt mit am Adaptermodul vorhandenen Gegenelektroden 20. Fig. 3 zeigt eine mögliche Realisierung der am Testmodul 2 angeordneten Kontaktelektroden 17 in Form von Federkraft-beaufschlagten Kontaktstiften 19, die mit an der Unterseite des Adaptermoduls 23 angebrachten Gegenelektroden 20 in Kontakt treten.

Je nach elektrischer Komponenten-Ausstattung des DUTs erfolgt über die Kabelverbindung 18 von Seiten des Testsignalgenerators 1 auch eine elektrische Energieversorgung des zu prüfende DUTs.

Das Testmodul 2 verfügt zudem über eine zweite Aufnahmestruktur 21 in Art einer schubladenfachartig ausgebildeten Ausnehmung, siehe Figur 1, in die die elektrische Zusatzkomponente 4, vorzugsweise in Form einer Induktionsspulen- und/oder Antennenanordnung, über die kontaktlos elektrische Energie sowie Messsignale übertragbar sind.

Wahlweise ist die Steuer- und Auswerteeinheit 3 unmittelbar mit dem Testmodul 2, siehe Kabelverbindung 22`, oder mit der elektrischen Zusatzkomponente 4, siehe Kabelverbindung 22, verbunden. Über die jeweilige Kabelverbindung 22, 22' werden die seitens der Kontaktelektroden 17 erfassten Messsignale zur Steuer- und Auswerteeinheit 3 übertragen werden können. Ebenso kann eine Versorgung des DUTs mit elektrischer Energie über die Kabelverbindung 22, 22` erfolgen.

Zur elektrischen Kontaktierung des DUTs innerhalb eines Adaptermoduls 23 dienen bspw. die in Fig. 3 illustrierten Federkraft-beaufschlagten Kontaktstifte 19 und/oder Kontaktelektroden jeweils in Form einer Stecker-Buchse-Verbindung, wie dies in Fig. 5 illustriert ist. Fig. 5 zeigt ein Adaptermodul 23, das Steckbuchsenkontakte 26 aufweist, in die Steckkontakte 27 eines DUTs einfügbar sind. Die dritte Aufnahmestruktur 25 des Adaptermoduls 23 ermöglicht ein kraftbeaufschlagtes Einfügen des DUTs in das Adaptermodul 23 längs der Kraftrichtung F.

Grundsätzlich sind den Ausgestaltungsformen für die Ausbildung jeweils der ersten sowie auch dritten Aufnahmestruktur 5, 25 keine Grenzen gesetzt.

### Bezugszeichenliste

- 1: Testsignalgenerator
- 2: Testmodul
- 3: Steuer- und Auswerteeinheit
- 4: elektrische Zusatzkomponente
- 5: erste Aufnahmestruktur
- 6: elektrische Leiterplatte
- 7: elektrische/elektronische Komponente
- 8: Durchführungsplatte
- 9: elektrische Leiter
- 10: Kontaktstellen
- 11: Umhausung
- 12: medizinisches Implantat
- 13: Kopfteil
- 14: Steckerbuchse
- 15: Anlagefläche
- 16: Ausnehmung
- 17: Kontaktelektroden
- 18: Kabelverbindung
- 19: Kontaktstift
- 20: Gegenelektrode
- 21: zweite Aufnahmestruktur
- 22, 22': Kabelverbindung
- 23: Adaptermodul
- 24: Fügekontur
- 25: dritte Aufnahmestruktur
- 26: Steckerbuchse
- 27: Steckkontaktstift

## Patentansprüche

1. Anordnung zur Funktionsüberprüfung einer Vielzahl unterschiedlich konfektionierter Meßobjekte, sogenannte DUTs, jeweils in Form eines medizinischen Implantats (12) oder wenigstens eines Teils (6, 11) des medizinischen Implantats, mit
a) einem Testsignal-Generator (1),
b) einem Testmodul (2), das mit dem Testsignal-Generator (1) verbunden ist und eine erste Aufnahmestruktur (5) mit wenigstens einer Kontaktelektrode (17) aufweist, in die ein mit einem DUT lösbar fest verbundenes Adaptermodul (23) unter Ausbildung wenigstens eines elektrischen Kontaktes einsetzbar ist, sowie
c) einer Steuer- und Auswerteeinheit (3), die mit dem Testsignal-Generator (1) und dem Testmodul (2) mittel- oder unmittelbar drahtlos oder drahtgebunden verbunden ist **dadurch gekennzeichnet, dass** das Testmodul (2) eine zu der ersten Aufnahmestruktur (5) raumfest angeordnete zweite Aufnahmestruktur (21) besitzt, die in Art einer schubladenfachartigen Ausnehmung ausgebildet ist und in die eine mit dem DUT kontaktlos zum Zwecke einer elektrischen Energie- und/oder Signalübertragung in Wechselwirkung tretende, elektrische Zusatzkomponente (4) fügbar ist dass das Adaptermodul (23) eine individuell an das DUT angepasste dritte Aufnahmestruktur (25) mit wenigstens einer Kontaktelektrode (26) aufweist, in die das DUT unter Ausbildung wenigstens eines elektrischen Kontaktes (27) einsetzbar ist dass wenigstens zwei Adaptermodule (23) mit unterschiedlich ausgebildeten dritten Aufnahmestrukturen (25) vorgesehen sind, die jeweils einheitlich für das Einsetzen in die erste Aufnahmestruktur (5) des Testmoduls (2) ausgebildet sind, und
dass die erste Aufnahmestruktur (5) mit der wenigstens einen Kontaktelektrode (17) zur unmittelbaren lösbar festen Einfügung und elektrischen Kontaktierung eines DUTs ausgebildet ist.

2. Anordnung nach Anspruch 1, **dadurch gekennzeichnet, dass** die elektrische Zusatzkomponente (4) eine Induktionsspule und/oder eine Signalantenne umfasst.

3. Anordnung nach Anspruch 1 oder 2, **dadurch gekennzeichnet, dass** die Steuer- und Auswerteeinheit (3) mit der elektrischen Zusatzkomponente (4) drahtlos oder drahtgebunden verbunden ist.

4. Anordnung nach einem der Ansprüche 1 bis 3, **dadurch gekennzeichnet, dass** die erste Aufnahmestruktur (5) wenigstens eine mit dem Adaptermodul (23) in Kontakt bringbare Anlagefläche (15) aufweist, an der die wenigstens eine Kontaktelektrode (17) angeordnet ist, die im Zustand eines in die erste Aufnahmestruktur (5) eingesetzten Adaptermoduls (23) kraft- und formschlüssig mit einer Seitens des Adaptermoduls angebrachten Gegenelektrode (20) in Kontakt steht

5. Anordnung nach einem der Ansprüche 1 bis 4, **dadurch gekennzeichnet, dass** die dritte Aufnahmestruktur (25) wenigstens eine mit dem DUT in Kontakt bringbare Anlagefläche aufweist, an der die wenigstens eine Kontaktelektrode (26) angeordnet ist, die im Zustand eines in die dritte Aufnahmestruktur eingesetzten DUTs kraft- und formschlüssig mit einer Seitens des DUTs angebrachten Gegenelektrode (27) in Kontakt steht.

6. Anordnung nach Anspruch 4 oder 5 **dadurch gekennzeichnet, dass** die wenigstens eine Kontaktelektrode (26) und Gegenelektrode (27) in Art einer Stecker-Buchse-Kontaktstruktur ausgebildet ist

7. Anordnung nach einem der Ansprüche 4 bis 6,
**dadurch gekennzeichnet, dass** die wenigstens eine Kontaktelektrode und/oder Gegenelektrode in Form eines Federkraft-beaufschlagbaren, auslenkbar gelagerten Kontaktstiftes (19) ausgebildet ist.

8. Anordnung nach einem der Ansprüche 1 bis 7,
**dadurch gekennzeichnet, dass** das DUT eines der nachfolgenden elektrischen Komponenten ist:
- Elektrische Leiterplatine (6) eines medizinischen aktiven Implantats (12)
- Elektrische Leiterplatte (6) mit zu- und abführenden elektrischen Leitungen
- Medizinisches aktives Implantat mit wenigstens einer elektrischen Kontaktanordnung.

9. Anordnung nach Anspruch 8,
**dadurch gekennzeichnet, dass** das medizinische aktive Implantat (12) ein implantierbarer Puls-Generator (IPG) ist.

10. Anordnung nach einem der Ansprüche 1 bis 9,
**dadurch gekennzeichnet, dass** der Test-Generator (1) EKG-Signale generiert

11. Verwendung der Anordnung nach einem der Ansprüche 1 bis 10 zur Diagnose und/oder zur Aktualisierung eines medizinischen Implantats, im Rahmen eines Software-updates.

## Claims

1. Assembly for checking the function of a plurality of differently assembled measuring objects, known as DUTs, each in the form of a medical implant (12), or at least of a part (6, 11) of the medical implant, with
a) a test signal generator (1),
b) a test module (2) which is connected to the test signal generator (1) and comprises a first receiving structure (5) with at least one contact electrode (17) into which an adapter module (23) detachably firmly connected to a DUT, can be inserted forming at least one electrical contact, as well as
c) a control and evaluation unit (3), which is indirectly or directly connected to the test signal generator (1) and the test module (2) in a wireless or wired manner,
**characterised in that** the test module (2) has a second receiving structure (21) that is arranged fixed in space with regard to the first receiving structure (5) and is designed in the form of a drawer compartment-like recess, into which an electrical additional component (4) interacting in a contactless manner with the DUT for the purpose of electrical energy and/or signal transmission, can be fitted,
**in that** the adapter module (23) comprises a third receiving structure (25) individually adapted to the DUT with at least one contact electrode (26), into which the DUR can be inserted forming at least one electrical contact (27),
**in that** at least two adapter modules (23) with differently designed third receiving structures (25) are provided which are each standardly designed for insertion into the first receiving structure (5) of the test module (2), and
**in that** the first receiving structure (5) with the at least one contact electrode (17) is designed for the direct detachably fixed insertion and electrical contacting of a DUT.

2. Assembly according to claim 1, **characterised in that** the electrical additional component (4) comprises an induction coil and/or a signal antenna.

3. Assembly according to claim 1 or 2, **characterised in that** the control and evaluation unit (3) is connected to the electrical additional component (4) in a wireless or wired manner.

4. Assembly according to any one of claims 1 to 3 **characterised in that** the first receiving structure (5) comprises at least one contact surface (15) that can be brought into contact with the adapter module (23) and on which the at least one contact electrode (17) is arranged, which in the state of an adapter module (23) inserted in the first receiving structure (5), is positively and non-positively in contact with a counter electrode (20) applied on the part of the adapter module.

5. Assembly according to any one of claims 1 to 4 **characterised in that** the third receiving structure (25) comprises at least contact surface that can be brought in to contact with the DUT and on which the at least contact electrode (26) is arranged, which in the state of a DUT inserted into the third receiving structure is positively and non-positively in contact with a counter-electrode (27) applied on the part of the DUT.

6. Assembly according to claim 4 or 5 **characterised in that** the at least one contact electrode (26) and counter-electrode (27) is designed in the form of a plug-socket contact structure.

7. Assembly according to any one of claims 4 to 6, **characterised in that** the at least one contact electrode and/or counter-electrode is designed in the form of a spring-loaded contact pin (19) mounted in a deflectable manner.

8. Assembly according to any one of claims 1 to 7, **characterised in that** the DUT is one of the following electrical components:
- electrical printed circuit board (6) of a medically active implant (12)
- electrical printed circuit board (6) with suppling and dissipating electric lines
- medically active implant with at least one electrical contact arrangement

9. Assembly according to claim 8 **characterised in that** the medically active implant (12) is an implantable pulse generator (IPG).

10. Assembly according to any one of claims 1 to 9 **characterised in that** the test generator (1) generates ECG signals.

11. Use of the assembly according to any one of claims 1 to 10 for the diagnosis and/or updating of a medical implant as part of a software update.

## Revendications

1. Système pour vérifier la fonctionnalité d'une pluralité d'objets de mesure de confection différente, dits 'Dispositifs Sous Essai' (DSE), respectivement sous la forme d'un implant médical (12) ou au moins d'une partie (6, 11) de l'implant médical, avec
a) un générateur de signaux d'essai (1),
b) un module d'essai (2), qui est relié au générateur de signaux d'essai (1) et comporte une première structure de réception (5) avec au moins une électrode de contact (17), dans laquelle un module d'adaptation (23) fermement relié de façon amovible au DSE peut être inséré en constituant au moins un contact électrique, ainsi qu'
c) une unité de commande et d'évaluation (3), qui est reliée directement ou indirectement par fil ou sans fil au générateur de signaux d'essai (1) et au module d'essai (2),
**caractérisé en ce que** le module d'essai (2) possède une deuxième structure de réception (21) disposée de façon stabilisée par rapport à la première structure de réception (5), qui est constituée à la manière d'un évidement de compartiment de tiroir et dans lequel un composant auxiliaire (4) électrique peut être assemblé interagissant sans contact avec le DSE dans le but d'une transmission électrique d'énergie et/ou de signaux,
**en ce que** le module d'adaptation (23) comporte une troisième structure de réception (25) adaptée individuellement au DSE avec au moins une électrode de contact (26), dans laquelle le DSE peut être inséré en constituant au moins un contact électrique (27),
**en ce qu'**au moins deux modules d'adaptation (23) avec des troisièmes structures de réception (25) de constitution différente sont prévus, qui sont respectivement constitués de façon homogène pour l'insertion dans la première structure de réception (5) du module d'essai (2), et
**en ce que** la première structure de réception (5) est constituée avec au moins une électrode de contact (17) pour l'insertion directe fixe de façon amovible et la mise en contact électrique d'un dispositif sous essai (DSE) .

2. Système selon la revendication 1,
**caractérisé en ce que** le composant auxiliaire électrique (4) comprend une bobine à induction et/ou une antenne de signalisation.

3. Système selon la revendication 1 ou 2,
**caractérisé en ce que** l'unité de commande et d'évaluation (3) est reliée sans fil ou avec fil au composant auxiliaire électrique (4).

4. Système selon l'une quelconque des revendications 1 à 3,
**caractérisé en ce que** la première structure de réception (5) comporte au moins une surface d'appui (15) pouvant être mise en contact avec le module d'adaptation (23), sur laquelle est disposée au moins une électrode de contact (17) qui à l'état d'un module d'adaptation (23) inséré dans la première structure de réception (5) est en contact par conformité de force et de forme avec une contre-électrode (20) montée du côté du module d'adaptation.

5. Système selon l'une quelconque des revendications 1 à 4,
**caractérisé en ce que** la troisième structure de réception (25) comporte au moins une surface d'appui pouvant être mise en contact avec le dispositif sous essai (DSE), sur laquelle est disposée au moins une électrode de contact (26), qui à l'état d'un DES inséré dans la troisième structure de réception est en contact par conformité de force et de forme avec une contre-électrode (27) montée du côté du DSE.

6. Système selon la revendication 4 ou 5,
**caractérisé en ce qu'**au moins une électrode de contact (26) et une contre-électrode (27) est constituée à la manière d'une structure de contact connecteur-douille.

7. Système selon l'une quelconque des revendications 4 à 6, **caractérisé en ce qu'**au moins une électrode de contact et/ou une contre-électrode est constituée sous la forme d'une fiche de contact (19) pouvant être sollicitée par une force élastique, logée pouvant être déviée.

8. Système selon l'une quelconque des revendications 1 à 7,
**caractérisé en ce que** le dispositif sous essai (DSE) est un des composants électriques suivants :
- carte de circuits imprimés (6) d'un implant médical actif (12),
- circuit imprimé électrique (6),
avec des conducteurs électriques d'arrivée et de départ,
- implant médical actif avec au moins un système de contact électrique.

9. Système selon la revendication 8,
**caractérisé en ce que** l'implant médical actif (12) est un générateur d'impulsions implantable (GII).

10. Système selon l'une quelconque des revendications 1 à 9,
**caractérisé en ce que** le générateur d'essai (1) génère des signaux d'électrocardiogramme (ECG).

11. Utilisation du système selon l'une quelconque des revendications 1 à 10 pour le diagnostic et/ou l'actualisation d'un implant médical dans le cadre d'une mise à jour de logiciel.
